## Europäisches Patentamt
## European Patent Office
## Office européen des brevets

(19)

(11) Numéro de publication : **0 013 641**
**B1**

(12)

# FASCICULE DE BREVET EUROPÉEN

(45) Date de publication du fascicule du brevet :
**17.10.84**

(21) Numéro de dépôt : **80400011.5**

(22) Date de dépôt : **04.01.80**

(51) Int. Cl.³ : **G 01 R 31/28, G 01 S 7/40, G 01 S 13/52**

(54) **Dispositif de test automatique des filtres numériques des dispositifs d'élimination des échos fixes.**

(30) Priorité : **09.01.79 FR 7900419**

(43) Date de publication de la demande :
**23.07.80 Bulletin 80/15**

(45) Mention de la délivrance du brevet :
**17.10.84 Bulletin 84/42**

(84) Etats contractants désignés :
**DE GB IT NL SE**

(56) Documents cités :
**DE-A- 2 606 669**
**IEEE TRANSACTIONS ON AUDIO AND ELECTRO-ACOUSTICS, vol. AU-19, no. 1, mars 1971, New York US W. ROECKER "The application of digital filters for moving target indication", pages 72-77**
**Architektur digitaler Rechenanlagen (Springer-Verlag 1976 p. 142-146, 172, 173)**

(73) Titulaire : **THOMSON-CSF**
**173, Boulevard Haussmann**
**F-75379 Paris Cedex 08 (FR)**

(72) Inventeur : **Lepeve, Guy**
**"THOMSON-CSF" - SCPI 173, bld Haussmann**
**F-75360 Paris Cedex 08 (FR)**
Inventeur : **Duval, Didier**
**"THOMSON-CSF" - SCPI 173, bld Haussmann**
**F-75360 Paris Cédex 08 (FR)**

(74) Mandataire : **Benoit, Monique et al**
**THOMSON-CSF SCPI 173, Bld Haussmann**
**F-75379 Paris Cedex 08 (FR)**

## Description

La présente invention concerne des dispositifs de test des filtres numériques des équipements de détection électromagnétique tels que les radars et les sonars.

Dans les systèmes de détection électromagnétique, on utilise des filtres numériques au niveau des circuits vidéo dans les dispositifs chargés d'éliminer les signaux provenant d'échos de cibles fixes, dispositifs connus sous l'abréviation anglo-saxonne M.T.I.

L'utilisation de ces filtres est connue, elle consiste à effectuer une comparaison des signaux obtenus à un instant t avec ceux obtenus dans les mêmes conditions à l'instant t + Δt. Cependant la structure de ces filtres devient vite complexe lorsqu'on envisage un filtrage à plusieurs étages. Ces filtres peuvent avoir des défaillances accrues avec la complexité grandissante de leur structure, et en régime opérationnel, les défaillances sont difficilement détectables. D'ailleurs jusqu'à présent, il ne semble pas que les filtres utilisés dans des dispositifs M.T.I. soient testés en régime opérationnel. Ils sont testés normalement avant d'être utilisés et si l'utilisateur a des craintes ils sont à nouveau testés, mais en dehors du système qui les utilise.

Le document DE-A-2 606 669 décrit un procédé de test de systèmes numériques utilisant le contrôle de la parité. Un tel contrôle est plus particulièrement adapté au test des mémoires. Il ne paraît pas adapté au test d'un filtre numérique qui, comportant des mémoires et des opérateurs ne serait pas contrôlé dans son intégralité.

De plus le document DE-A-2 606 669 évoque sans la décrire la possibilité de test d'un système numérique en fournissant au système un signal binaire de test et en comparant la réponse du système avec une réponse théorique prédéterminée.

La présente invention vise à apporter une solution à ce problème de la détection des défaillances des filtres numériques en régime opérationnel, en effectuant des tests périodiques et automatiques, et ceci sans perte d'information.

Un filtre numérique M.T.I., comme cela apparaît dans le document cité « The Application of Digital Filters for Moving Target Indication » de W. Roecker, pages 72-77, publié dans IEEE Transaction on audio and electroacoustics vol. AU19 n° 1, de mars 1971 est organisé autour d'une mémoire comportant un nombre de cases distances dépendant de la portée du radar. Un filtre numérique fonctionne en multiplexage temporel, de sorte que l'on peut considérer que l'on a autant de filtres que de cases mémoires.

Suivant l'idée à la base de l'invention le dernier filtre est testé en permanence et la détection d'une anomalie indique, par suite du multiplexage temporel, un mauvais fonctionnement de l'ensemble des filtres.

Suivant l'invention un dispositif de test automatique en régime opérationnel des filtres numériques d'un dispositif d'élimination d'échos fixes est tel que défini dans la revendication 1.

Les avantages et caractéristiques de la présente invention seront décrits, dans l'exemple qui suit d'une réalisation, à l'aide des figures qui représentent :

la figure 1, un exemple de réalisation d'un filtre numérique à trois étages,

la figure 2, un diagramme schématique d'un dispositif d'élimination d'échos fixes équipé de deux filtres numériques,

la figure 3, un diagramme schématique d'un dispositif selon la figure 2 comportant un dispositif de test suivant l'invention,

la figure 4, un exemple de réalisation détaillé de l'invention selon le diagramme de la figure 3.

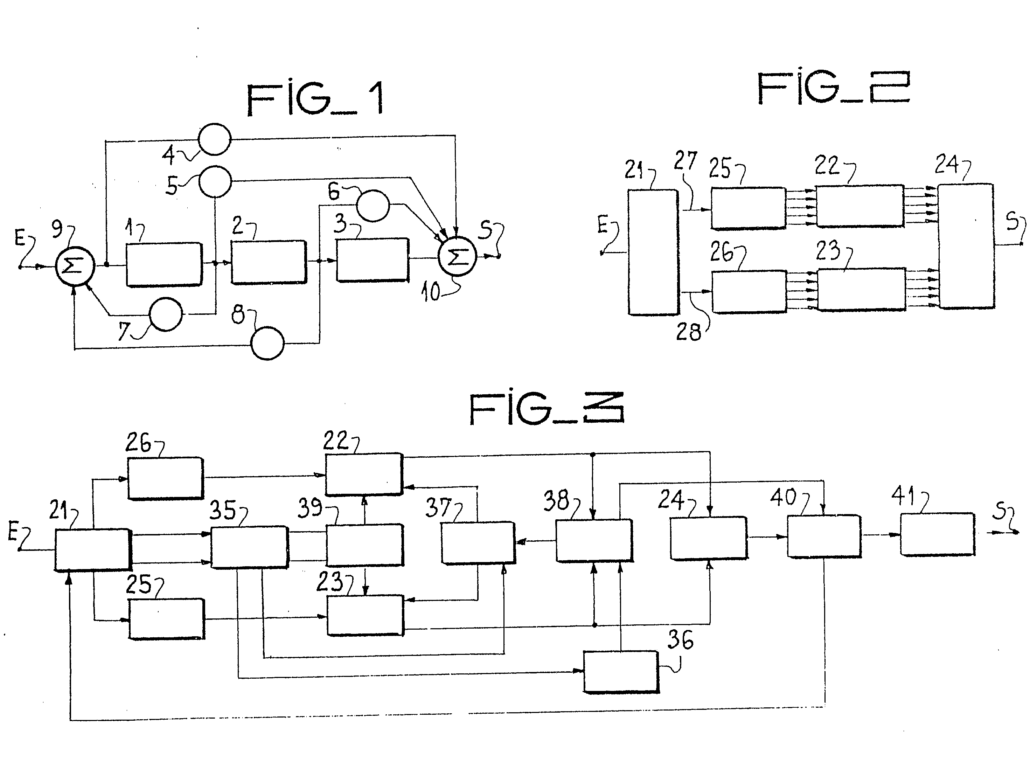

La figure 1 représente un filtre numérique à trois étages comportant trois mémoires, du type registre à décalage 1, 2, 3 et cinq multiplicateurs numériques de constantes algébriques 4, 5, 6, 7 et 8. Le fonctionnement de ce type de filtre est connu et ne sera que brièvement rappelé ici, on pourra à ce sujet se rapporter aux nombreux ouvrages spécialisés traitant de la question comme, par exemple, celui de J. Darricau, intitulé « Physique et théorie du Radar » et publié chez Sodipe, édition 1973.

Les signaux entrant dans ces filtres ont été préalablement échantillonnés, et chaque échantillon a eu son amplitude codée sous forme d'un mot binaire ; p mots formant une récurrence et correspondant par exemple à un balayage distance d'un radar, entrent successivement dans la mémoire 1 en traversant un sommateur 9 qui fait l'addition de ces p mots avec les p mots des autres mémoires ; cette addition est une addition algébrique du fait de la présence des multiplicateurs numériques 7 et 8 qui multiplient les mots binaires contenus dans les mémoires 1, 2 par des constantes algébriques fixes. Cette opération permet l'élimination partielle des échos fixes. Pour améliorer le résultat, l'opération est reproduite dans les trois étages en faisant remarquer que l'entrée dans la mémoire 1 de p mots provoque le passage des p mots, qui y étaient stockés, dans la mémoire 2 et ainsi de suite ; à la sortie du filtre après une sommation par l'additionneur 10, les mots binaires correspondant aux échos fixes représentent des impulsions d'amplitude très faible, et on peut les considérer comme éliminés.

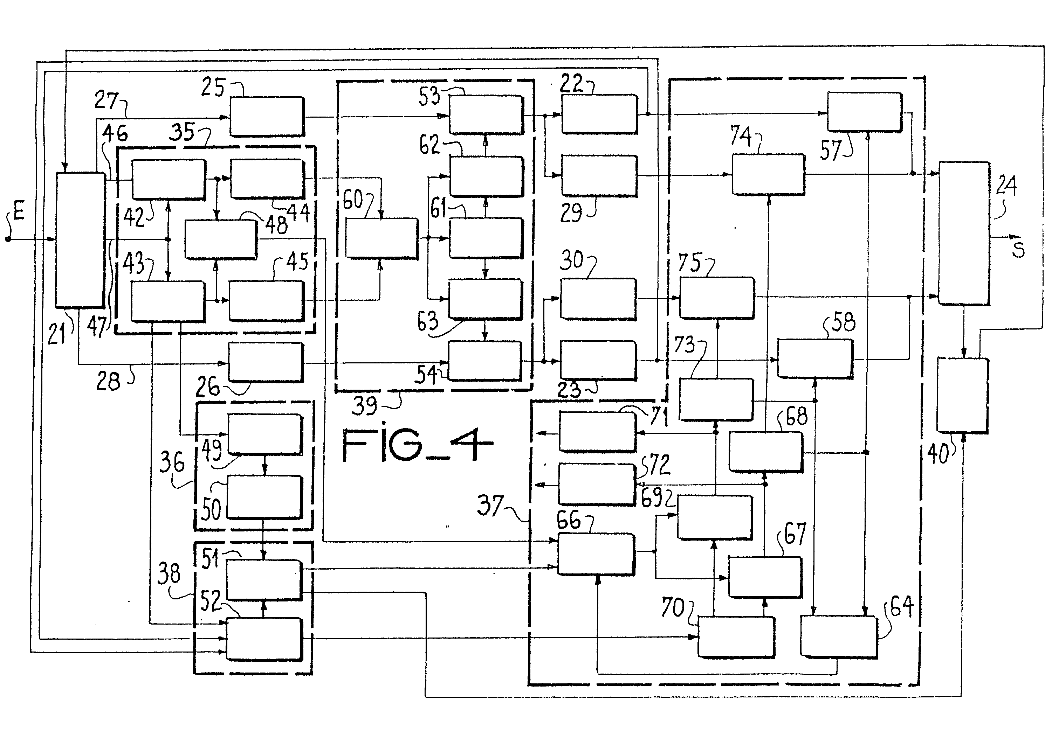

La figure 2 représente un diagramme schématique d'un dispositif d'élimination des échos fixes équipé de deux filtres numériques. Dans ce diagramme le circuit 21 est l'ensemble de détection radar ou sonar jusqu'au niveau des circuits vidéo.

Il délivre sur deux sorties en quadrature 27, 28 des signaux vidéo récurrents et échantillonnés dont chaque échantillon est converti en binaire par un convertisseur analogique numérique 25, 26. Chacun des convertisseurs est relié à un filtre numérique 22, 23 du type décrit, à titre d'exemple, dans la figure 1. Ces filtres éliminent les échos fixes et donnent en sortie les signaux d'échos mobiles sous la forme de mots binaires à plusieurs bits. Les signaux sont envoyés à un détecteur numérique de module 24. Dans ce circuit les signaux des deux voies sont élevés au carré, puis on y effectue leur somme, pour enfin extraire en sortie la racine carrée du nombre obtenu par addition, ce qui redonne l'amplitude du signal d'écho reçu par le circuit de détection radar ou sonar 21 débarrassé des échos fixes.

Dans le cas d'une défaillance partielle ou totale de l'un des filtres il était, dans l'art antérieur, très difficile et souvent impossible d'apprécier, surtout en fonctionnement, la dégradation de l'information reçue. Pour remédier à une défaillance possible on arrêtait périodiquement le fonctionnement du système de détection pour vérifier le fonctionnement correct des filtres numériques. La présente invention vise à supprimer cet inconvénient et la figure 3 montre un dispositif de test suivant l'invention réalisé pour un dispositif d'élimination d'échos fixes.

Outre les éléments du dispositif d'élimination d'échos fixes déjà décrits dans la figure 2, à savoir un circuit de détection 21, deux convertisseurs analogiques-numériques 25, 26, deux filtres numériques 22, 23 un détecteur de module 24, le dispositif suivant l'invention comporte un circuit de comptage et de décodage d'échantillons et de récurrences 35, un circuit d'élaboration du signal de test 39, un circuit d'adressage et de mémoire contenant les réponses théoriques des filtres utilisés 36, un circuit de comparaison 38, situé entre la mémoire 36, et la sortie du filtre testé (22 ou 23), un circuit de décision et d'élaboration de signal de défaillance 37, un circuit de réajustement du gain en cas de panne 40, et un convertisseur numérique analogique 41.

Le fonctionnement du dispositif de la figure 3 est le suivant : le signal de sortie analogique du circuit de détection 21 est récurrent et échantillonné. Au dernier échantillon d'une récurrence donnée, déterminé par le circuit de comptage 35, le générateur de test 39 injecte une impulsion binaire sur l'entrée numérique de l'un des filtres sans déconnecter ledit filtre du circuit de détection 21 ; le choix de ce filtre est effectué alternativement. La réponse du filtre testé est comparée à l'aide du circuit de comparaison 38 au contenu de la mémoire adressée 36 choisi par le circuit de comptage 35. Le résultat de la comparaison est ensuite envoyé à un circuit de décision 37, qui, en cas de défaillance, inhibe le filtre défaillant.

Le circuit 40 réajuste le gain de l'ensemble de réception 21 en fonction de la valeur moyenne d'un certain nombre de mots binaires successifs représentatifs du niveau du signal à la sortie du détecteur de module 24, s'il reçoit une impulsion de commande donnée par le comparateur 38.

Une description plus détaillée de l'invention dans le cas de l'exemple précédent est donnée à l'aide de la figure 4 qui reprend la figure 3 et y ajoute deux filtres numériques 29, 30, deux circuits « et » 74, 75. Le circuit de comptage et décodage 35 comprend par exemple un compteur d'échantillons 42, un compteur de récurrences 43, un décodeur de numéros d'échantillon 44, un décodeur de numéros de récurrence 45 et un circuit de décodage et d'élaboration de signal de validation de test 48. Le circuit d'élaboration de signal de test 39 comprend par exemple trois circuits « et » 60, 62, 63, deux groupes de deux circuits « ou » 53, 54 et une bascule 61. Le circuit d'adressage et de mémoire 36 comprend un circuit d'adressage 49 et une mémoire 50. Le circuit de comparaison 38 comprend un comparateur de mots binaires 51 et un multiplexeur 52. Le circuit de décision de défaillance et d'inhibition 37 comprend par exemple trois circuits « et » 66, 67, 69, une bascule 70, deux circuits monostables 71, 72, deux bascules de mémorisation 68, 73, un circuit « ou » 64, et deux groupes de circuits « et » 57, 58.

Le fonctionnement du dispositif de la figure 4 dont la description est donnée, est le suivant :

Le signal d'horloge 46, de fréquence égale à celle d'échantillonnage, incrémente le compteur d'échantillons 42 prévu par exemple pour 4 096 échantillons. Le signal de synchronisation 47 remet à zéro ce compteur à chaque début de récurrence et incrémente le compteur de récurrence 43 prévu par exemple pour 246 récurrences. Au dernier pas de comptage, par exemple, lorsque les bits de sortie de ces compteurs sont tous à 1, les décodeurs 44 et 45 constitués par exemple de circuits « et » délivrent une impulsion binaire. Quand les deux décodeurs donnent des impulsions simultanées le circuit « et » 60 génère une impulsion binaire qui, par l'intermédiaire des circuits « et » 62, 63, et la bascule 61, provoque l'apparition d'une impulsion binaire sur une des entrées d'un des groupes de circuits « ou » 53, 54. Ce groupe de circuits provoque alors la mise au niveau logique 1 de tous les bits d'entrée du filtre. La bascule 61 agit ici comme un commutateur de choix du filtre testé. A chaque passage par le numéro de la récurrence de test, qui est le dernier pas de comptage du circuit 43, le circuit d'adressage de mémoire 49 reçoit un mot binaire correspondant à la sortie de mémoire 50 de la réponse théorique du filtre choisi.

Le comparateur 51, qui peut être ici par exemple un ensemble de circuits « ou exclusif », reçoit d'une part le contenu adressé de la mémoire 50 et d'autre part la réponse du filtre testé à l'impulsion binaire qui lui a été appliquée, ledit filtre étant sélectionné par un multiplexeur 52 jouant le rôle d'un commutateur synchronisé avec le circuit bistable 61 du circuit d'élaboration du signal de test 39, par l'intermédiaire du compteur de récurrences 43.

Le comparateur 51 délivre une impulsion binaire de signal de défaillance si le mot binaire de la mémoire et celui du filtre 22, 23, sélectionné par le multiplexeur 52, ne sont pas identiques. Cette impulsion se trouve appliquée simultanément avec celle du signal de lecture de test généré par le circuit de décodage 48 sur le circuit « et » 66 ; à la sortie de ce circuit le signal est alors 1, ce qui entraîne également un signal 1 à la sortie d'un des circuits « et » 67, 69 choisi alternativement par la bascule 70 par l'intermédiaire du multiplexeur 52, ce qui a pour effet d'annuler en permanence la sortie du filtre concerné par la délivrance d'un signal zéro appliqué à l'un des circuits « et » 57 et 58, l'ordre d'annulation étant donné par les bascules 68 et 73. Parallèlement, l'impulsion « de défaillance » provoque le basculement d'un des monostables 71, 72 dont les sorties sont connectées à des voyants de signalisation. Si le circuit de test délivre une impulsion de défaillance et d'inhibition sur chaque filtre le circuit 64 délivre une impulsion zéro empêchant toutes les inhibitions par le circuit 66 et déclenche une alarme de défaillance de système de test. Cet exemple de réalisation d'un dispositif de test conformément à la présente invention n'est pas limitatif. Il est en particulier évident pour l'homme de l'art que les circuits d'élaboration de signal de test 39 et de décision de défaillance 37 peuvent être réalisés à partir de circuits élémentaires différents.

Suivant le concept de l'invention on peut contrôler un nombre quelconque de filtres à condition d'adapter la capacité des différents circuits au nombre de filtres. Le cas particulier d'un seul filtre rend non nécessaire l'utilisation du circuit de décision de défaillance 37 du fait de la non-nécessité d'inhibition du filtre défaillant.

L'invention s'applique aux filtres numériques montés en série ou en parallèle, l'impulsion binaire de test étant appliquée à l'entrée du filtre testé et la réponse du filtre étant prélevée sur la sortie du filtre testé.

En outre l'invention s'applique aux filtres numériques non récursifs. Dans ce cas on supprime les circuits de comptage de récurrence et on définit simplement une période de test à partir d'un nombre fixe d'échantillons.

Suivant l'invention on peut conjuger l'inhibition d'un filtre défaillant avec son remplacement par un filtre de rechange. Cette commutation peut par exemple se faire en reliant la seconde sortie des bascules 73, 68 à deux circuits « et » 74, 75 commandant l'utilisation de deux filtres de rechange 29 et 30 à la place des filtres défaillants.

En outre on pourra injecter tout autre signal de test binaire qu'un ensemble d'impulsions courtes sur les bits d'entrée des filtres.

On a ainsi décrit un dispositif de test des filtres numériques d'un dispositif d'élimination d'échos fixes de radar ou sonar.

**Revendications**

1. Dispositif de test automatique en régime opérationnel des filtres numériques d'un dispositif d'élimination d'échos fixes, pour radar ou sonar, lesdits filtres (22, 23) recevant sur leurs entrées, à chaque récurrence du radar ou sonar un signal échantillonné élaboré par le circuit de détection (21) du radar ou sonar, chaque échantillon étant converti en un mot binaire par l'intermédiaire des moyens convertisseur analogique-numérique prévus entre ledit circuit de détection et les filtres, caractérisé en ce qu'il comprend, connecté au circuit de détection (21) du radar ou sonar, un circuit de comptage et de décodage (35) détectant une récurrence prédéterminée et dans cette récurrence, l'instant à la fin de cette récurrence où le test est exécuté, un circuit de sélection du filtre numérique à tester et d'élaboration d'un signal binaire de test (39) commandé par le circuit de comptage et de décodage (35), et appliquant à l'un des filtres numériques (22, 23) à la fin de la récurrence prédéterminée le signal binaire de test, un comparateur (38) comparant la réponse du filtre numérique testé (22, 23) avec une réponse théorique enregistrée dans une mémoire (36) adressable et un circuit (40) commandé par le comparateur (38) réajustant le gain du circuit de détection (21) en cas de défaillance d'un filtre.

2. Dispositif de test automatique suivant la revendication 1, caractérisé en ce que le circuit de comptage et de décodage (35) comprend un circuit de comptage (42) des échantillons du signal d'une récurrence, un circuit de comptage (43) des récurrences, associés respectivement à des circuits de décodage (44, 45) déclenchant au dernier pas de comptage desdits circuits de comptage (42, 23) le signal binaire de test.

3. Dispositif de test automatique suivant l'une des revendications 1 ou 2, caractérisé en ce que le circuit de sélection du filtre à tester et d'élaboration de signal binaire de test (39) comporte un circuit ET (60) connecté aux circuits de décodage (44, 45) et un circuit bascule (61) connecté au circuit ET (60) et délivrant l'impulsion de test, alternativement à l'un des filtres numériques (22, 23).

4. Dispositif de test automatique suivant la revendication 3, caractérisé en ce que le circuit bascule (61) est connecté aux entrées des filtres à tester par l'intermédiaire de circuits OU (53, 54) assurant le choix en alternance d'un circuit filtre, et appliquant un niveau logique 1 à tous les bits d'entrée du circuit filtre choisi.

5. Dispositif de test automatique selon la revendication 1, caractérisé en ce que la mémoire (36) adressable est une mémoire morte (50) dont le circuit d'adressage (49) est commandé par le circuit de comptage des récurrences (43).

6. Dispositif de test automatique selon la revendication 5, caractérisé en ce que le comparateur (38) comporte un multiplexeur (52), recevant les sorties des filtres numériques (22, 23) et dont une sortie est reliée au circuit de comparaison proprement dit (51), qui reçoit d'autre part le contenu de la mémoire morte (50), et dont une seconde sortie délivre un signal de synchronisation.

7. Dispositif de test automatique suivant la revendication 6, caractérisé en ce qu'il comporte, outre le circuit (40) de réajustement du gain du circuit de détection (21), des moyens (37) d'inhibition automatique des filtres défaillants qui, par l'intermédiaire de circuits ET (57, 58), commandés par le signal de sortie du circuit de comparaison (51) à travers un autre circuit ET (66) contrôlé par le circuit de comptage et de décodage (35), appliquent un niveau logique zéro sur tous les bits de sortie du ou des filtres défaillants, sous le contrôle du signal de synchronisation.

8. Dispositif de test automatique suivant l'une des revendications 1 ou 7, caractérisé en ce qu'il comporte des filtres de remplacement (29, 30) montés en parallèle sur les filtres numériques testés (22, 23), le remplacement d'un filtre défaillant par un filtre de remplacement étant assuré par des circuits logiques (68, 73, 74, 75) commandés par le signal de sortie du comparateur (38).

9. Dispositif de test automatique suivant l'une des revendications 1, 7 ou 8, caractérisé en ce qu'il comporte des moyens de signalisation automatique (71, 72), commandés par le signal de sortie du comparateur (38), et indiquant les filtres défaillants.

10. Dispositif de test automatique suivant la revendication 9, caractérisé en ce que les moyens de signalisation automatique sont des circuits monostables (71, 72) dont une sortie est reliée à un circuit optique de signalisation.

11. Dispositif de test automatique suivant la revendication 7, caractérisé en ce que les moyens (37) d'inhibition des filtres comportent des circuits (64) annulant l'inhibition des filtres si ceux-ci sont testés comme étant tous défaillants.

12. Dispositif de test automatique selon la revendication 1, caractérisé en ce que le circuit (40) de réajustement du gain, commandé, en cas de défaillance d'un filtre, par le comparateur (38), mesure la valeur moyenne des signaux à la sortie d'un détecteur de module (24) contenu dans le dispositif d'élimination d'échos fixes et réajuste automatiquement le niveau de sortie du circuit de détection (21) du radar ou du sonar, pour conserver un niveau moyen constant du signal à la sortie du détecteur de module (24).

## Claims

1. Device for automatically testing in the operational state digital filters of a steady echos eliminating device for radar and sonar installations, said filters (22, 23) receiving at their input terminals, at each radar or sonar recurrence, a sampled signal produced by the radar or sonar detection circuit (21), each sample being converted into a binary term by digital-to-analogue converting means provided between said detection circuit and the filters, characterized in that it comprises, connected to the detection circuit (21) of the radar or sonar, a counting and decoding circuit (35) detecting a predetermined recurrence and, in this recurrence, the instant at the end of said recurrence at which the test is carried out, a circuit for selecting the digital filter to be tested and for producing a binary test signal (39), controlled by the counting and decoding circuit (35) and applying to one of the digital filters (22, 23) at the end of said predetermined recurrence, the binary test signal, a comparator (38) for comparing the response of the tested digital filter (22, 23) to a theoretical response stored in an addressable memory (36), and a circuit (40) controlled by the comparator (38) for readjusting the gain of the detection circuit (21) in case of failure of a filter.

2. Automatic testing device according to claim 1, characterized in that the counting and decoding circuit (35) comprises a circuit (42) for counting the samples of the signal of one recurrence, and a circuit (23) for counting the recurrences, associated respectively to decoding circuits (44, 45) which trigger the binary test signal at the last counting step of said counting circuits (42, 23).

3. Automatic testing device according to any of claims 1 or 2, characterized in that the circuit for selecting the filter to be tested and for producing the binary test signal (39) comprises an AND circuit (60) connected to the decoding circuits (44, 45), and a flip-flop circuit (61) connected to the AND circuit (60) and delivering the test pulse alternately to one of the digital filters (22, 23).

4. Automatic testing device according to claim 3, characterized in that the flip-flop circuit (61) is connected to the input terminals of the filters to be tested through the intermediary of OR circuits (53, 54) effecting the alternating selection of a filter circuit and applying a logical level 1 to all input bits of the selected filter circuit.

5. Automatic testing device according to claim 1, characterized in that the addressable memory (36) is a read-only memory (50), the addressing circuit (49) of which is controlled by the recurrence counting circuit (43).

6. Automatic testing device according to claim 5, characterized in that the comparator (38) comprises a multiplexer (52), receiving the outputs of the digital filters (22, 23), and an output terminal of which is connected to the comparing circuit proper (51) which, on the other hand, receives the content of the read-only memory (50), and a second output terminal of which provides a synchronizing signal.

7. Automatic testing device according to claim 6, characterized in that it comprises, in addition to the circuit (40) for the readjusting the gain of the detection circuit (21), means (37) for automatically inhibiting the faulty filters, which means, through the intermediary of AND circuits (57, 58) actuated by the output signal of the comparing circuit (51) through another AND circuit (66) controlled by the counting and decoding circuit (35), apply a logical zero level to all output bits of the faulty filter(s), under the control of the synchronizing signal.

8. Automatic testing device according to any one of claims 1 to 7, characterized in that it comprises replacement filters (29, 30) connected in parallel to the tested digital filters (22, 23), the replacement of a faulty filter by a replacement filter being effected by logic circuits (68, 73, 74, 75) actuated by the output signal of the comparator (38).

9. Automatic testing device according to one of claims 1, 7 or 8, characterized in that it comprises automatic alarm indicating means (71, 72) actuated by the output signal of the comparator (38) and indicating the faulty filters.

10. Automatic testing device according to claim 9, characterized in that the automatic alarm indicating means are monostable circuits (71, 72) an output terminal of which is connected to an optical indicator circuit.

11. Automatic testing device according to claim 7, characterized in that the filter inhibiting means (37) comprise circuits (64) for canelling the inhibition of the filters when the filters are tested as all being faulty.

12. Automatic testing device according to claim 1, characterized in that the gain readjusting circuit (40) actuated in the presence of a faulty filter by the comparator (38) measures the average value of the signals at the output terminal of a module detector (24) contained in the steady echo eliminating device and readjusts automatically the level of the output of the radar or sonar detecting circuit (21), so as to maintain a constant average level of the signal at the output terminal of the module detector (24).

**Ansprüche**

1. Automatische Prüfvorrichtung zum Prüfen arbeitender digitaler Filter einer Einrichtung zur Unterbindung von ständigen Echos, für Radar- oder Sonargeräte, wobei diese Filter (22, 23) bei jeder Radar- oder Sonardurchgangswiederholung an ihren Eingängen ein vom Radar- bzw. Sonarsuchstromkreis (21) erzeugtes, gemustertes Signal empfangen und jedes Mustersignal durch zwischen dem Suchstromkreis und den Filtern angeordnete analog-digitale Wandlermittel in einen binären Ausdruck umgewandelt wird, dadurch gekennzeichnet, dass sie einen mit dem Radar- bzw. Sonarsuchstromkreis (21) verbundenen Zähl- und Entschlüsselungsstromkreis (35) aufweist, der eine vorbestimmte Wiederholung und hierbei den Zeitpunkt der Beendigung dieser Wiederholung, bei der die Prüfung erfolgt sowie einen Wählstromkreis zum Wählen des zu prüfenden digitalen Filters und zur Erzeugung eines binären Prüfsignals (39) aufweist, welcher Stromkreis vom Zähl- und Entschlüsselungsstromkreis (35) gesteuert wird, wobei der Wählstromkreis bei Beendigung der vorbestimmten Wiederholung an einen der digitalen Filter (22, 23) das binäre Prüfsignal anlegt, ferner einen Vergleicher (Komparator) (38), der die Antwort des zu prüfenden digitalen Filters (22, 23) mit der in einem zugänglichen Speicher (36) gespeicherten theoretischen Antwort vergleicht, und einen vom Vergleicher (38) betätigten Stromkreis (40), der bei Schadhaftigkeit eines Filters den Verstärkungsfaktor des Suchstromkreises (21) korrigiert.

2. Automatische Prüfvorrichtung nach Anspruch 1, dadurch gekennzeichnet, dass der Zähl- und Entschlüsselungsstromkreis (35) einen Stromkreis (42) zum Zählen der Muster des Signals einer Wiederholung, sowie einen Stromkreis (43) zum Zählen der Wiederholungen der Signale umfasst, wobei jeder dieser Stromkreise mit einem Entschlüsselungsstromkreis (44, 45) verbunden ist, der beim letzten Zählschritt der Zählstromkreise (42, 23) das binäre Prüfsignal auslöst.

3. Automatische Prüfvorrichtung nach einem der Ansprüche 1 oder 2, dadurch gekennzeichnet, dass der Stromkreis zum Wählen des zu prüfenden Filters und zur Erzeugung des binären Prüfsignals (39) einen mit den Entschlüsselungsstromkreisen (44, 45) verbundenen UND-Stromkreis (60), sowie eine Kippschaltung (61) aufweist, die mit dem UND-Stromkreis (60) verbunden ist und abwechselnd an einen der digitalen Filter (22, 23) den Prüfimpuls abgibt.

4. Automatische Prüfvorrichtung nach Anspruch 3, dadurch gekennzeichnet, dass die Kippschaltung (61) an die Eingänge der zu prüfenden Filter unter Zwischenschaltung von Stromkreisen (53, 54) angeschlossen ist, die abwechselnd einen Filterstromkreis wählen, indem sie allen binären Eingangsstellen (Bits) des gewählten Filterstromkreises einen logischen Wertpegel 1 beiordnen.

5. Automatische Prüfvorrichtung nach Anspruch 1, dadurch gekennzeichnet, dass der zugängliche Speicher (36) ein Totspeicher (50) ist, dessen Zugangsstromkreis (49) durch den Stromkreis (43) zum Zählen der Wiederholungen gesteuert wird.

6. Automatische Prüfvorrichtung nach Anspruch 5, dadurch gekennzeichnet, dass der Komparator (38) einen Multiplexer (52) aufweist, der die Ausgangssignale der digitalen Filter (22, 23) empfängt, wobei ein Ausgang des Multiplexers mit dem eigentlichen Vergleichsstromkreis (51) verbunden ist, der ferner den Inhalt des Totspeichers (ROM) (50) empfängt, und ein zweiter Ausgang des Multiplexers ein Synchronisiersignal abgibt.

7. Automatische Prüfvorrichtung nach Anspruch 6, dadurch gekennzeichnet, dass sie ausser dem Stromkreis (40) zum Korrigieren des Verstärkungsfaktors des Suchstromkreises (21) das automatische Ausschalten der schadhaften Filter bewirkende Mittel (37) besitzt, die unter Zwischenschaltung von durch das Ausgangssignal des Vergleichsstromkreises (51) gesteuerten UND-Schaltungen (57, 58) unter der Kontrolle des Synchronisiersignals den binären Ausgangsstellen (Bits) einen logischen Nullwertpegel einordnen, wobei diese Steuerung der UND-Schaltungen (57, 58) unter Zwischenschaltung einer weiteren, vom Zähl- und Entschlüsselungsstromkreis (35) gesteuerten UND-Schaltung (66) erfolgt.

8. Automatische Prüfvorrichtung nach einem der Ansprüche 1 bis 7, dadurch gekennzeichnet, dass sie Ersatzfilter (30, 29) aufweist, die mit den zu prüfenden digitalen Filtern (22, 23) parallel geschaltet sind, wobei das Ersetzen eines schadhaften Filters durch einen Ersatzfilter vermittels vom Ausgangssignal des Komparators (38) gesteuerter logischer Stromkreise (68, 73, 74, 75) erfolgt.

9. Automatische Prüfvorrichtung nach einem der Ansprüche 1, 7 oder 8, dadurch gekennzeichnet, dass sie durch das Ausgangssignal des Komparators (38) gesteuerte automatische Anzeigemittel (71, 72) umfasst, die die schadhaften Filter bezeichnen.

10. Automatische Prüfvorrichtung nach Anspruch 9, dadurch gekennzeichnet, dass die automatischen Anzeigemittel aus monostabilen Stromkreisen (71, 72) bestehen, wobei einer der Ausgänge derselben an einen Sichtanzeigestromkreis angeschlossen ist.

11. Automatische Prüfvorrichtung nach Anspruch 7, dadurch gekennzeichnet, dass die Filterausschaltmittel (37) Stromkreise (64) aufweisen, die die Ausschaltung der Filter aufheben, wenn dieselben sich bei der Prüfung alle als schadhaft erweisen.

12. Automatische Prüfvorrichtung nach Anspruch 1, dadurch gekennzeichnet, dass der bei Schadhaftigkeit eines Filters durch den Komparator (38) betätigte Verstärkungsfaktorkorrekturstromkreis (40) den Mittelwert der Signale am Ausgang einer zur Einrichtung zur Unterbindung ständiger Echos gehörigen Modulsucheinrichtung (24) misst und automatisch den Ausgangspegel des Radar- bzw. Sonarsuchstromkreises (21) zwecks Beibehaltung eines konstanten Mittelwertes des Pegel des Ausgangssignals der Modulsucheinrichtung (24) korrigiert.

# FIG_1

# FIG_2

# FIG_3

0013641

FIG_4